# EUROPEAN PATENT SPECIFICATION

(11) **EP 1 648 060 B1**
(45) Date of publication and mention of the grant of the patent: **23.07.2008**
(21) Application number: 05256393.9
(22) Date of filing: 14.10.2005
(51) Int. Cl.: H01S 5/183

(54) **Funnel structure vertical external cavity surface-emitting laser (VECSEL)**
Oberflächenemittierender Laser mit externem vertikalem Resonator (VECSEL) und mit stromführender Struktur
Laser à émission de surface à cavité externe verticale (VECSEL) avec structure à guidage de courant

(30) Priority: 14.10.2004 KR 2004082075; 13.09.2005 US 224144
(43) Date of publication of application: 19.04.2006
(73) Proprietor: Samsung Electronics Co., Ltd., Yeongtong-gu Suwon-si, Gyeonggi-do (KR)
(72) Inventor: Taek, Kim, Seongnam-si Gyeonggi-do (KR)
(74) Representative: Greene, Simon Kenneth

(56) References cited:
- US-A- 5 493 577
- US-A1- 2004 032 892
- US-A1- 2004 066 820
- YOUNG E W ET AL: "COMPARISON OF WAVELENGTH SPLITTING FOR SELECTIVELY OXIDIZED, ION IMPLANTED, AND HYBRID VERTICAL-CAVITY SURFACE-EMITTING LASERS" IEEE JOURNAL OF QUANTUM ELECTRONICS, IEEE SERVICE CENTER, PISCATAWAY, NJ, US, vol. 39, no. 5, May 2003 (2003-05), pages 634-639, XP001175802 ISSN: 0018-9197

## Description

### BACKGROUND

The present invention is related to a semiconductor laser, and more particularly to surface emitting lasers and vertical external cavity surface emitting lasers (VECSEL).

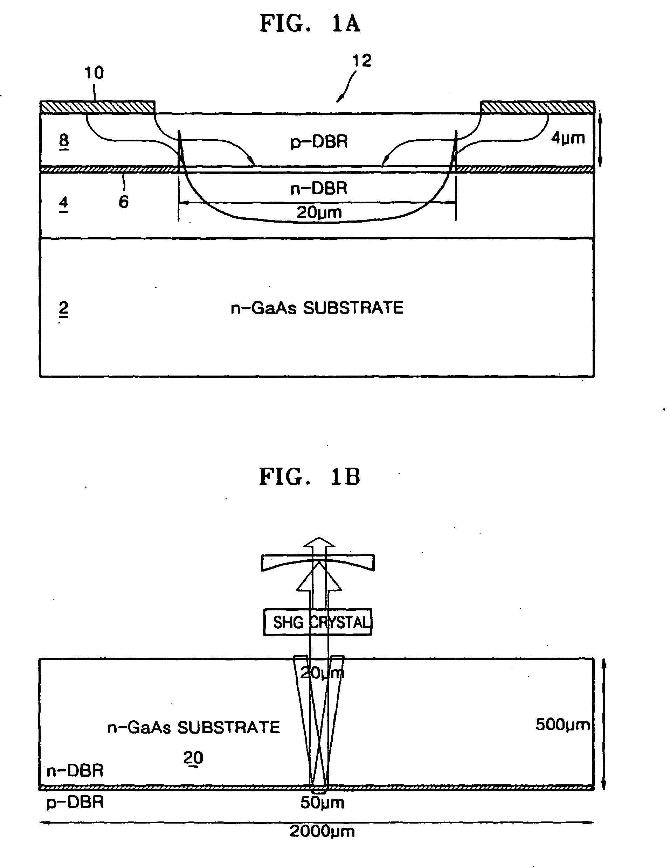

Referring to Fig. 1A, a conventional vertical cavity surface emitting laser (VCSEL) is illustrated in a cross-sectional view. As illustrated, the various layers of the VCSEL include an n-GaAs (Gallium Arsenide) substrate 2, an active layer 6 between an n-DBR (distributed Bragg reflector) layer 4 and a p-DBR (distributed Bragg reflector) layer 8, and a top conductive layer 10. The (optical) cavity 12 is perpendicular to the layers, which allows for the optical beam to be emitted in the vertical direction. In the configuration illustrated the aperture is approximately 20µm. However, due to the non-uniform carrier distribution in the active layer (current crowding) as illustrated in superimposed graph 14, the conventional VCSEL design is limited in its fundamental transverse operation mode. For example, it is difficult to achieve designs that generate a single mode signal with greater than 7-8µm apertures, which limits the fundamental transverse power mode in the conventional VCSEL.

Fig. 1B illustrates a related art Novalux Extended Cavity Surface Emitting Laser (NECSEL) as discloses in U.S. Patent No. 6,243,407. The NECSEL laser's emitting area is said to be tens of times larger than conventional VCSELs, thereby allowing scaling to high power levels. The larger emitting area was designed to address the current crowding problems with the conventional VCSEL designs. Because the substrate thick, it is said to provide enough distance from the active region such that the carriers can diffuse laterally and thereby provide a more uniform carrier distribution in the active region. However, to enlarge the aperture size with uniform carrier distribution, the NECSEL uses an extremely thick GaAs substrate 20 (e.g. >100um)

US 5,493,577 describes a number of VCSEL structures. In one, an aperture is provided above an active region, an upper mirror above the aperture, and an electrode with an opening above the lower aperture. The current path is narrower through the aperture.

Other VCSEL structures showing this current narrowing are provided by US 2004/0032892, US 2004/0066820, and by Young et al. in "Wavelength splitting for selectively oxidized, ion implanted , and hybrid VCSELS".

### SUMMARY

Embodiments of the present invention addresses these and other concerns. According to one aspect, there is provided a surface emitting laser apparatus according to claim 1. The apparatus includes a first substrate disposed between a first electrode layer and a first reflective layer. An active region is disposed between the first reflective layer and a second reflective layer. A current blocking layer is disposed between the active region and a second electrode layer to form an aperture. A first semiconductor layer can be disposed between the second electrode layer and the second reflective layer. The second electrode layer can have an opening substantially aligned with the aperture. A current funnel region can be located in a cavity formed between the aperture and the opening of the second electrode. The current funnel region can be configured to facilitate conduction through the cavity.

### BRIEF DESCRIPTION OF THE DRAWINGS

The above and other objects, features, and advantages of the present invention will become more apparent in light of the following detailed description in conjunction with the drawings, in which like reference numerals identify similar or identical elements, and in which:
FIG. 1A is a cross-section of layers which illustrate a conventional VCSEL architecture;
FIG. 1B is a cross-section of layers which illustrate a conventional NECSEL architecture;
FIG. 2A is a cross-section of layers of a surface emitting laser according to at least one embodiment of the present invention;
FIG. 2B is an illustration of a carrier profile for the surface emitting laser of Fig. 2A according to at least one embodiment of the present invention;
FIG. 3 is a cross-section of layers of a surface emitting laser according to at least one embodiment of the present invention;
FIG. 4 is a cross-section of layers of a surface emitting laser according to at least one embodiment of the present invention;
FIG. 5 is a cross-section of a vertical external cavity surface emitting laser (VECSEL) according to at least one embodiment of the present invention;
FIG. 6 is a illustration of an alternative location of the current blocking layer in accordance with at least one embodiment of the present invention; and
FIG. 7 is a cross-section of layers of a surface emitting laser according to an example.

### DETAILED DESCRIPTION

Aspects of the invention are disclosed in the following description and related drawings directed to specific embodiments of the invention. Alternate embodiments may be devised without departing from the scope of the invention. Additionally, well-known elements of the invention will not be described in detail or will be omitted so as not to obscure the relevant details of the invention.

The word "exemplary" is used herein to mean "serving as an example, instance, or illustration." Any embodiment described herein as "exemplary" is not necessarily to be construed as preferred or advantageous over other embodiments. Likewise, the term "embodiments of the invention" does not require that all embodiments of the invention include the discussed feature, advantage or mode of operation.

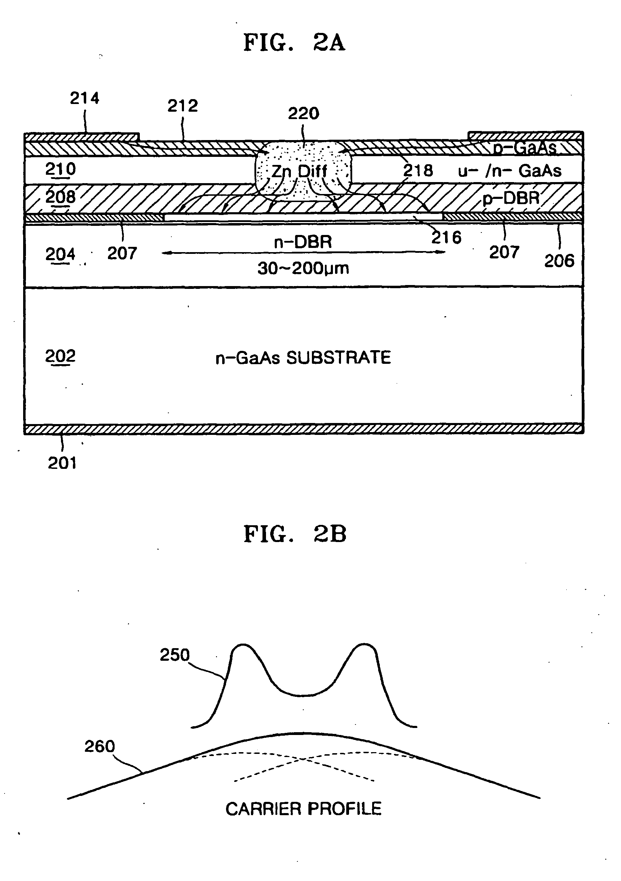

Turning to the drawings, Fig. 2A illustrates at least one exemplary embodiment of the invention. As illustrated in the cross-sectional view, an undoped or n-doped Gallium Arsenide (n-GaAs) layer 210 and a p-GaAs layer 212 can be grown on p-DBR layer 208. The reflectivity of the p-DBR layer can vary (e.g., in a range from about 30% to 90%). The carriers are prevented from passing through the undoped or n-doped GaAs because of the p-n-p structure, but without substantially attenuating the light generated in the active region 206. Using zinc (Zn) diffusion or implantation technique, a funnel like current pass region 220 can be formed toward the center of the vertical cavity. Those skilled in the art will appreciate that more than one region can be formed in the vertical cavity and multiple regions of uniform or varying dimensions can be used to further adjust or optimize the carrier profile.

As can be seen by comparing Figs. 1A and 2A, the base substructure is similar to the conventional VCSEL construction. Accordingly, a detailed explanation of the layers and operation will not be provided. As illustrated in Fig. 2A, the p-n-p structure described above is located on the conventional VCSEL construction. Specifically, the n-GaAs substrate 202, n-DBR layer 204, active region 206, insulator (e.g., oxide) layer 207 and p-DBR layer 208 form the base structure. The un-doped or n-doped (n-GaAs) layer 210 and a p-GaAs layer 212 are located above the p-DBR layer 208, which forms the p-n-p structure that generally prevents carrier conduction between the layers. However, the current funnel region 220 formed across the p-n-p structure facilitates carrier conduction (e.g., as illustrated by arrows 218) in the cavity. As illustrated, the current funnel region 220 is generally aligned with the cavity formed by the top electrode 214 and aperture 216.

Referring to Fig. 2B, the carrier profile of the embodiment of Fig. 2A is illustrated. The carrier profile is determined by two-step diffusion through the current funnel region and the active region. For example, the carrier profile through the current funnel region (e.g., Zn diffusion) 250 and active region 260 is illustrated. A uniform carrier distribution 260 can be obtained at the active region when compared to the conventional carrier profile 14 of Fig. 1A. The uniform active region size can be controlled by, the thickness of top GaAs layer, undoped or n-doped GaAs layer, p-DBR layer and the size of the funnel. For example, a narrower width of the funnel promotes a uniform carrier profile at the active region. To enlarger the uniform carrier profile size at the active region, a wider width of the funnel is preferred. However, in this case, the thickness of the p-DBR layer is increased. The p-DBR layer thickness can be increased by various techniques, such as using 3/4 lambda layers instead of 1/4 lambda layers and /or inserting a p-GaAs dummy layer on the top of the DBR.

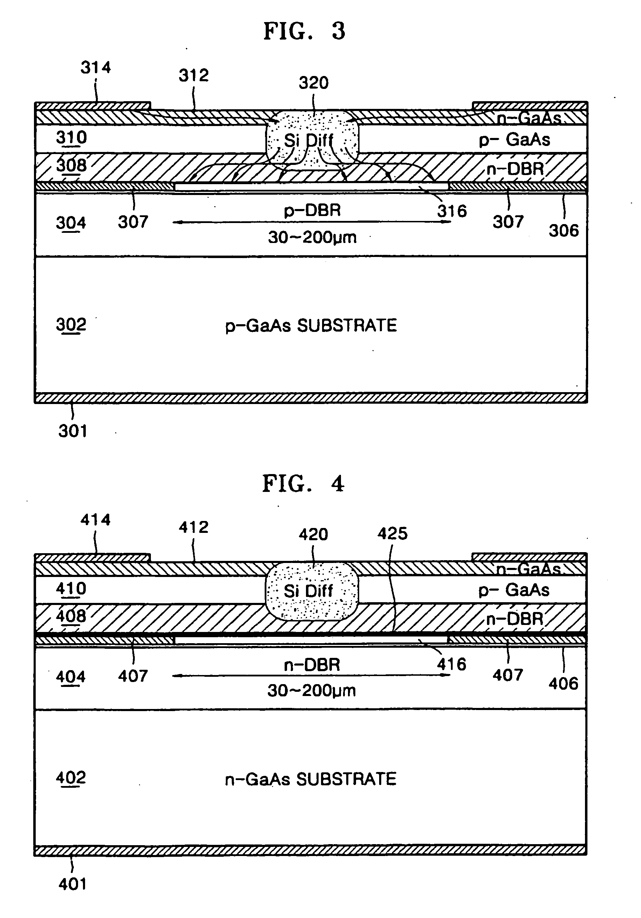

The embodiment of Fig. 2A can be generally considered to be a hole carrier configuration. The Zn is used as an acceptor dopant to form the current funnel region; however, other types of acceptor dopants can be used as will be appreciated by those skilled in the art. In contrast, the embodiment illustrated in Fig. 3 is an electron carrier configuration and has a n-p-n structure and uses a donor type dopant (e.g., Si). Further, those skilled in the art will appreciate that the voltage bias will be reversed from the hole carrier configuration (e.g., the top electrode is the ground electrode).

Referring to Fig. 3, an alternative embodiment of the invention is illustrated. As discussed above, this configuration can be referred to as an electron carrier configuration and generally has the dopant types reversed from the embodiment illustrated in Fig. 2A. Accordingly, the base structure is formed by a p-GaAs substrate 302, p-DBR layer 304, active region 306, insulator (e.g., oxide) layer 307 and n-DBR layer 408. A p-GaAs layer 310 and n-GaAs layer 312 are located above the n-DBR layer 308, which forms the n-p-n structure that generally prevents carrier conduction between the layers. The current funnel region 320 formed across the n-p-n structure in the cavity is a silicon (Si) diffusion region. As illustrated, the current funnel region 320 is generally aligned with the cavity formed by the top electrode 314 and aperture 316. Generally, the electron carrier configuration of Fig. 3 has a flatter carrier profile in the active region than the hole carrier configuration of Fig. 2A.

Referring to Fig. 4, another alternative embodiment of the invention is illustrated. This configuration can be also referred to as an electron carrier configuration and generally has a donor dopant type. However the base structure includes a tunnel junction 425 and has similar type reflective layers 404 and 408. As illustrated, the base structure is formed by a n-GaAs substrate 402, a first n-DBR layer 304, active region 406, insulator (e.g., oxide) layer 407 and a second n-DBR layer 408. Additionally, a tunnel junction is located between the active region 406 and the second n-DBR layer 408. The tunnel junction 425 is formed of a highly doped n⁺/p⁺ junction as is known in the art. A p-GaAs layer 410 and n-GaAs layer 412 are located above the n-DBR layer 408, which forms the n-p-n structure that generally prevents carrier conduction between the layers. The current funnel region 420 formed across the n-p-n structure in the cavity is a silicon (Si) diffusion region. As illustrated, the current funnel region 420 is generally aligned with the cavity formed by the top electrode 414 and aperture 416. Incorporating the tunnel junction 425 allows the for the n-p-n structure to be used with the n-GaAs base substrate configuration. As discussed above, because electron diffusion (as opposed to hole diffusion) is used this configuration has a flatter carrier profile in the active region 406 and faster carrier mobility than the configuration of Fig. 2A.

The foregoing embodiments are merely illustrative and are not intended to limit the invention to the illustrated configurations and/or materials. Accordingly, an embodiment of the invention can include a surface emitting laser apparatus comprising a first substrate (e.g., 202, 302, 402) disposed between a first electrode layer (e.g., 201, 301, 401) and a first reflective layer (e.g., 204, 304, 404). An active region (e.g., 206, 306, 406) can be disposed between the first reflective layer and a second reflective layer (e.g., 208, 308, 408). A current blocking layer (e.g., 207, 307, 407) can be disposed above the active region to form an aperture (e.g., 216, 316, 416). A first semiconductor layer (e.g., 210, 310, 410) and a second semiconductor layer (e.g., 212, 312, 412) can be disposed between a second electrode layer (e.g., 214, 314, 414) and the second reflective layer. The second electrode layer can have an opening substantially aligned with the aperture. A current funnel region (e.g., 220, 320, 420) can be located in a cavity formed between the aperture and the opening of the second electrode. The current funnel region can be configured to facilitate conduction across the second semiconductor layer, the first semiconductor layer, and second reflective layer.

As discussed and illustrated in the foregoing, the first substrate and the first reflective layer can be of the same doping (e.g., n-type or p-type). Additionally, in some embodiments the second reflective layer is of an opposite doping. Further the first semiconductor layer is of opposite doping from the second semiconductor layer. For example, as illustrated in Fig. 2A, the first substrate is an n-GaAs substrate, the first reflective layer is an n-DBR layer, the second reflective layer is a p-DBR layer, and the first and second semiconductor layers are n-GaAs and p-GaAs, respectively. Alternatively, as illustrated in Fig. 3, first substrate is a p-GaAs substrate, the first reflective layer is a p-DBR layer, the second reflective layer is a n-DBR layer, and the first and second semiconductor layers are p-GaAs and n-GaAs, respectively.

In further embodiments, such as illustrated in Fig. 4, a tunnel junction layer can be disposed between the active region and the second reflective layer. In this configuration, the first substrate and the first and second reflective layers are of the same doping. However, the first semiconductor layer is still of opposite doping from the second semiconductor layer. For example, the first substrate can be an n-GaAs substrate, the first reflective and second reflective layers are n-DBR, and the first and second semiconductor layers are p-GaAs and n-GaAs, respectively.

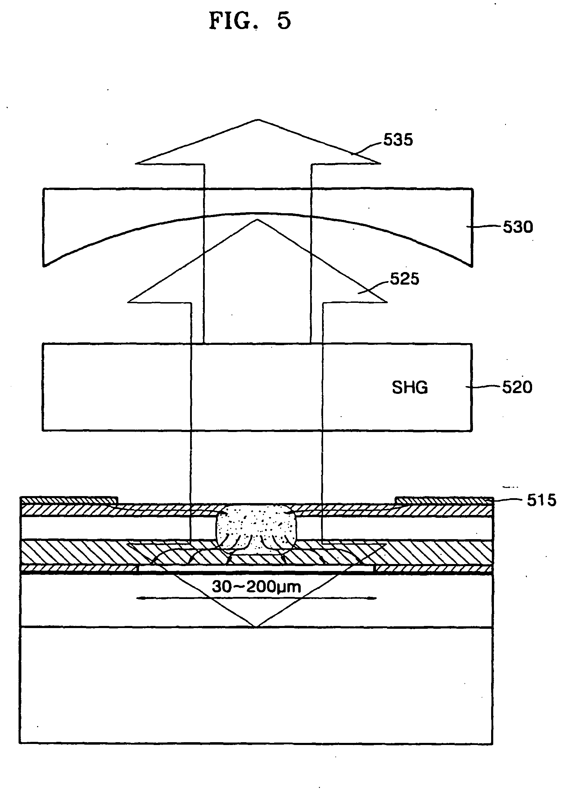

Referring to Fig 5, yet another configuration is illustrated in accordance with at least one embodiment of the present invention. Accordingly, a surface emitting laser apparatus 510, such as those discussed above can further include an output coupler 530 and a non-linear optical element 520. The non-linear optical element 520 is disposed between the second conductor 515 and the output coupler 530. The non-linear optical element 520 and output coupler 530 are substantially aligned with the cavity formed between the aperture and the opening of the second electrode 515. As illustrated, the non-linear optical element 520 can be a frequency doubling element such as a second-harmonic-generation (SHG) crystal to double an output frequency the surface emitting laser. Accordingly, the infrared laser beam 525 is converted to visible light laser beam 535 and propagated from the output coupler 530. As illustrated, non-linear optical element 520 and output coupler 530 are located external to the surface emitting laser apparatus 510, thus forming a VECSEL.

As stated in the foregoing description, the invention is not limited to the materials illustrated. For example, the DBR layers can be formed of 4~ 40 pairs of AlAs / GaAs or AI(Ga)As/(AI)GaAs to provide high reflectivity for the laser cavity and prevent carrier diffusion. The active region can include 1~3 quantum wells (QW) as pump absorption and gain regions. For example, InGaAs QWs (or InGaAs Quantum dot, or InAs(N) QD, or GaInNAs QW or QD) provide gain and GaAsP layers can provide strain relief. In addition to zinc (Zn) other acceptors such as Mg or C can be used to form the current funnel region. As will be appreciated by those skilled in the art, various modifications substitutions to the specific materials can be made without departing from the scope of the present invention.

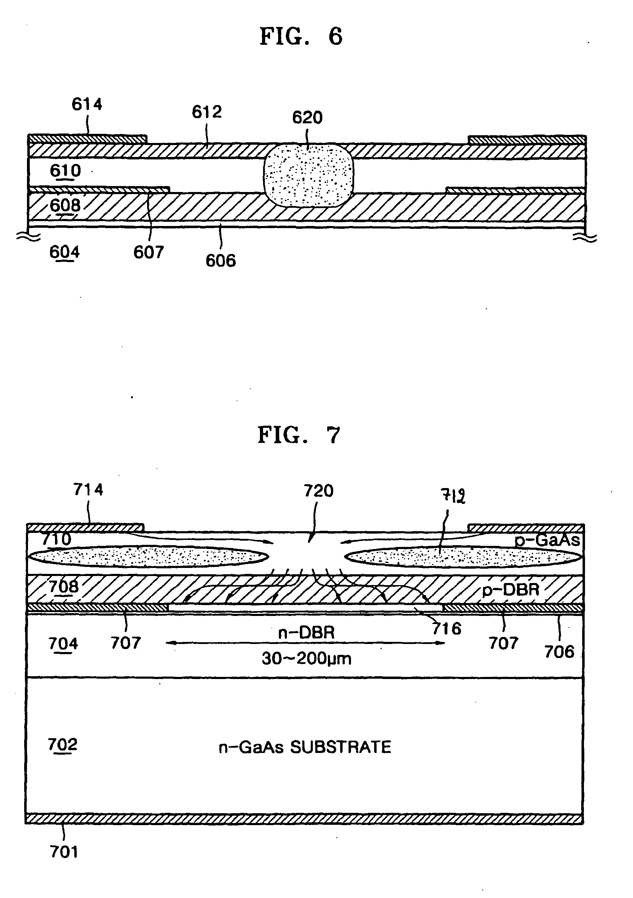

Additionally, as previously stated, embodiments of the invention are not limited to the examples illustrated herein. For example, as illustrated in Fig. 6, the current blocking layer 607 can be disposed on the second reflective layer 608. Accordingly, alternate embodiments of the invention can include the alternate location of the current blocking layer as illustrated in Fig. 6. For example, the active region 606 can be disposed between the first reflective layer 604 and the second reflective layer 608. A current blocking layer 607 can be disposed on the second reflective layer 608 to form an aperture. A first semiconductor layer 610 and a second semiconductor layer 612 can be disposed between a second electrode layer 614 and the second reflective layer 608. The second electrode layer 614 can have an opening substantially aligned with the aperture. A current funnel region 620 can be located in a cavity formed between the aperture and the opening of the second electrode. The current funnel region can be configured to facilitate conduction across the second semiconductor layer, the first semiconductor layer, and second reflective layer, as in the previously illustrated embodiments. All layers have not been illustrated in Fig. 6 to emphasize that the embodiments of Figs. 2A, 3 and 4 can be modified to correspond to the configuration illustrated in Fig. 6. Accordingly, these and other modifications to the illustrated embodiments are considered to be within the scope of the present invention and the present invention is not limited to the arrangements illustrated herein.

From the foregoing description, those skilled in the art will appreciate that embodiments of the present invention achieve low free carrier absorption, without resorting to the thick n-GaAs substrate of the NECSEL design. Likewise, embodiments of the invention allow for simple processing (i.e., no back side processing is required). Further, efficient frequency doubling can be achieved and a compact array is possible due to smaller size, when compared to the NECSEL design. Additionally, conventional techniques can be used in forming the present invention. However, when using the diffusion process, it is preferable to keep the diffusion process low enough temperature (e.g., <650 C as related to the QW growth temperature) so as not to deteriorate the quality of QW.

Another example is illustrated in Fig. 7, but not necessarily according to the present invention. In the illustrated example, instead of using dopant diffusion or implantation, an ion or proton implantation technique can be used to define a funnel structure as illustrated in Fig. 7. As will be appreciated by those skilled in the art, the n-p-n or p-n-p current blocking structures previously discussed is not used in this embodiment. For example, as illustrated an electrode layer 701, an n-GaAs substrate 702, n-DBR layer 704, active region 706, insulator (e.g., oxide) layer 707 and p-DBR layer 708 form the base structure. A p-GaAs layer 710 is located between the p-DBR layer 708 and a second electrode layer 714. The current funnel region 720 is defined by a high resistivity region 712 (e.g., formed by proton implantation in p-GaAs layer 710) that is generally aligned with the cavity formed by the top electrode 714 and aperture 716.

Accordingly, an example can include a surface emitting laser apparatus having a first substrate (e.g., 702) disposed between a first electrode layer (e.g., 701) and a first reflective layer (e.g., 704). An active region (e.g., 706) can be disposed between the first reflective layer and a second reflective layer (e.g., 708). A current blocking layer (e.g., 707) can be disposed between the active region and a second electrode layer (e.g., 708) to form an aperture. A first semiconductor layer (e.g., 710) can be disposed between the second electrode layer and the second reflective layer. The second electrode layer has an opening substantially aligned with the aperture. A current funnel region (e.g., 720) can be located in a cavity between the aperture and the opening of the second electrode and is configured to facilitate conduction in the cavity. Additionally, the current funnel region can be defined by a high resistivity region (e.g., 712) disposed about the cavity in the first semiconductor layer. The high resistivity region can be formed by at least one of proton implantation and ion implantation.

Further, the first substrate can be an n-GaAs substrate, the first reflective layer an n-DBR layer, the second reflective layer a p-DBR layer, and the first semiconductor layer a p-GaAs layer. Alternatively, the first substrate can be a p-GaAs substrate, the first reflective layer a p-DBR layer, the second reflective layer an n-DBR layer, and the first semiconductor layer an n-GaAs layer. The active region can be formed of multiple quantum wells, as previously discussed. Likewise an output coupler and a non-linear optical element can be disposed between the second electrode and the output coupler, The non-linear optical element and the output coupler are substantially aligned with the cavity formed between the aperture and the opening of the second electrode external to the second electrode layer to form a vertical external cavity surface emitting laser (VECSEL), such as illustrated in Fig. 5.

It should be emphasized that the terms "comprises" and "comprising", when used in this specification as well as the claims, are taken to specify the presence of stated features, steps or components; but the use of these terms does not preclude the presence or addition of one or more other features, steps, components or groups thereof.

Various embodiments of Applicants' invention have been described, but it will be appreciated by those of ordinary skill in this art that these embodiments are merely illustrative and that many other embodiments are possible. The intended scope of the invention is set forth by the following claims, rather than the preceding description, and all variations that fall within the scope of the claims are intended to be embraced therein.

## Claims

1. A surface emitting laser apparatus comprising:
a first substrate (202, 302, 402, 702) disposed between a first electrode layer (201) and a first reflective layer (204, 304, 404, 604, 704);
a second electrode layer (214, 314, 414, 614, 714) having an opening;
an active region (206, 306, 406, 606, 706) disposed between the first reflective layer and a second reflective layer (208, 308, 408, 608, 708);
a current blocking layer (207, 307, 407, 607, 707) disposed between the active region (206, 306, 406, 606, 706) and the second electrode layer (214, 314, 414, 614, 714) to form an aperture (216, 316, 416, 616, 716) aligned with the opening; and
a first semiconductor layer (210, 310, 410, 610, 710) disposed between the second electrode layer (214, 314, 414, 614, 714) and the second reflective layer (208, 308, 408, 608, 708);
**characterised by** a current funnel region that is a doped region of raised conductivity that extends through the first semiconductor layer (210, 310, 410, 610, 710), the current funnel region being a region of higher conductivity than the laterally surrounding region to funnel current.

2. The apparatus of claim 1 wherein the current funnel region is in a cavity and configured to facilitate conduction in the cavity.

3. The apparatus of claim 1, further comprising:
a second semiconductor layer (212, 312, 412, 612, 712) disposed between the first semiconductor layer (210, 310, 410, 610, 710) and the second electrode (214, 314, 414, 614, 714), wherein the second reflective layer (208, 308, 408, 608, 708), the first semiconductor layer (210, 310, 410, 610, 710) and the second semiconductor layer (212, 312, 412, 612, 712) form an p-n-p structure, and wherein the current funnel region is formed by at least one of zinc (Zn) diffusion and zinc (Zn) implantation in the cavity.

4. The apparatus of claim 3, wherein the first substrate (202, 302, 402, 702) is an n-GaAs substrate, the first reflective layer (204, 304, 404, 604, 704) is an n-DBR, the second reflective layer (208, 308, 408, 608, 708) is a p-DBR layer, and the first (210, 310, 410, 610, 710) and second (212, 312, 412, 612, 712) semiconductor layers are n-GaAs and p-GaAs, respectively.

5. The apparatus of claim 1, further comprising:
a second semiconductor layer (212, 312, 412, 612, 712) disposed between the first semiconductor layer (210, 310, 410, 610, 710) and the second electrode (214, 314, 414, 614, 714), wherein the second reflective layer (208, 308, 408, 608, 708), the first semiconductor layer (210, 310, 410, 610, 710) and the second semiconductor layer (212, 312, 412, 612, 712) form an n-p-n structure, and wherein the current funnel region is formed by at least one of silicon (Si) diffusion and silicon (Si) implantation in the cavity

6. The apparatus of claim 5, wherein the first substrate (302) is a p-GaAs substrate, the first reflective layer (304) is a p-DBR, the second reflective layer (308) is a n-DBR layer, and the first and second semiconductor layers (310, 312) are p-GaAs and n-GaAs, respectively.

7. The apparatus of claim 1, wherein the first substrate (202, 302, 402, 702) is an n-GaAs substrate, the first reflective layer (204, 304, 404, 604, 704) is an n-DBR layer, the second reflective layer (208, 308, 408, 608, 708) is a p-DBR layer, and the first semiconductor layer (210, 310, 410, 610, 710) is a p-GaAs layer.

8. The apparatus of claim 1, wherein the first substrate (202, 302, 402, 702) is a p-GaAs substrate, the first reflective layer (204, 304, 404, 604, 704) is a p-DBR layer, the second reflective layer (208, 308, 408, 608, 708) is an n-DBR layer, and the first semiconductor layer (210, 310, 410, 610, 710) is an n-GaAs layer.

9. The apparatus of any preceding claim, wherein the active region (206, 306, 406, 606, 706) is formed of multiple quantum wells.

10. The apparatus according to claim 1 further comprising a second semiconductor layer (212, 312, 412, 612, 712) between the first semiconductor layer (210, 310, 410, 610, 710) and the second electrode (214, 314, 414, 614, 714).

11. The apparatus of claim 10, wherein the current funnel region (220) is in the laser cavity and configured to facilitate conduction across second reflective layer, the first semiconductor layer (210, 310, 410, 610, 710), and the second semiconductor layer (212, 312, 412, 612, 712).

12. The apparatus of claim 11, wherein the current funnel region (220) is formed by at least one of zinc (Zn) diffusion and zinc (Zn) implantation.

13. The apparatus of claim 11, wherein the current funnel region (220) is formed by at least one of silicon (Si) diffusion and silicon (Si) implantation.

14. The apparatus of claim 10, wherein the first substrate (202, 302, 402, 702) and the first reflective layer (204, 304, 404, 604, 704) are of the same doping, wherein the second reflective layer (208, 308, 408, 608, 708) is of an opposite doping and wherein the first semiconductor layer (210, 310, 410, 610, 710) is of opposite doping from the second semiconductor layer (212, 312, 412, 612, 712).

15. The apparatus of any of claims 11 to 14 further comprising:
a tunnel junction layer disposed between the active region and the second reflective layer.

16. The apparatus of claim 15, wherein the first substrate (202, 302, 402, 702) and the first and second reflective layers (204, 208) are of the same doping, and wherein the first and second semiconductor layers (210, 212) are of opposite doping.

17. The apparatus of claim 16, wherein the first substrate (202, 302, 402, 702) is an n-GaAs substrate, the first reflective layer (204, 304, 404, 604, 704) and second reflective layer (208, 308, 408, 608, 708) are n-DBR layers, and the first and second semiconductor layers (210, 212) are p-GaAs and n-GaAs, respectively.

18. The apparatus of any preceding claim, further comprising:
an output coupler; and
a non-linear optical element disposed between the second electrode and the output coupler, wherein the non-linear optical element and the output coupler are substantially aligned with the cavity formed between the aperture and the opening of the second electrode.

19. The apparatus of claim 18, wherein the non-linear optical element is a second-harmonic-generation (SHG) crystal.

20. The apparatus of claim 19, wherein the non-linear optical element is configured to double an output frequency the surface emitting laser.

21. The apparatus of claim 18, 19 or 20, wherein the non-linear optical element and the output coupler are external to the second electrode layer and forms vertical external cavity surface emitting laser (VECSEL).

22. The apparatus of claim 18, 19, 20 or 21, wherein the output coupler is a mirror.

23. The apparatus of any preceding claim, wherein the current blocking layer is disposed on the active region.

24. The apparatus of any preceding claim, wherein the current blocking layer is disposed on the second reflective layer.

## Patentansprüche

1. Oberflächenemittierende Laservorrichtung umfassend:
ein erstes Substrat (202, 302, 402, 702), das zwischen einer ersten Elektrodenschicht (201) und einer ersten Reflexionsschicht (204, 304, 404, 604, 704) angeordnet ist,
eine zweite Elektrodenschicht (214, 314, 414, 614, 714) mit einer Öffnung,
eine aktive Region (206, 306, 406, 606, 706), die zwischen der ersten Reflexionsschicht und einer zweiten Reflexionsschicht (208, 308, 408, 608, 708) angeordnet ist,
eine Stromsperrschicht (207, 307, 407, 607, 707), die zwischen der aktiven Region (206, 306, 406, 606, 706) und der zweiten Elektrodenschicht (214, 314, 414, 614, 714) so angeordnet ist, dass sie eine Apertur (216, 316, 416, 616, 716) bildet, die mit der Öffnung fluchtet, und
eine erste Halbleiterschicht (210, 310, 410, 610, 710), die zwischen der zweiten Elektrodenschicht (214, 314, 414, 614, 714) und der zweiten Reflexionsschicht (208, 308, 408, 608, 708) angeordnet ist,
**gekennzeichnet durch** eine Stromführungsregion, die eine dotierte Region mit erhöhter Leitfähigkeit aufweist, die sich **durch** die erste Halbleiterschicht (210, 310, 410, 610, 710) erstreckt, wobei die Stromführungsregion eine Region mit höherer Leitfähigkeit als die sie seitlich umgebende Region ist, so dass Strom geführt wird.

2. Vorrichtung nach Anspruch 1, wobei die Stromführungsregion in einer Kavität liegt und so konfiguriert ist, dass sie Leitung in der Kavität erleichtert.

3. Vorrichtung nach Anspruch 1, ferner umfassend:
eine zweite Halbleiterschicht (212, 312, 412, 612, 712), die zwischen der ersten Halbleiterschicht (210, 310, 410, 610, 710) und der zweiten Elektrode (214, 314, 414, 614, 714) angeordnet ist, wobei die zweite Reflexionsschicht (208, 308, 408, 608, 708), die erste Halbleiterschicht (210, 310, 410, 610, 710) und die zweite Halbleiterschicht (212, 312, 412, 612, 712) eine p-n-p-Struktur bilden und wobei die Stromführungsregion durch Zink(Zn)-Diffusion und/oder Zink(Zn)-Implantation in der Kavität gebildet ist.

4. Vorrichtung nach Anspruch 3, wobei das erste Substrat (202, 302, 402, 702) ein n-GaAs-Substrat ist, die erste Reflexionsschicht (204, 304, 404, 604, 704) eine n-DBR-Schicht ist, die zweite Reflexionsschicht (208, 308, 408, 608, 708) eine p-DBR-Schicht ist und die erste (210, 310, 410, 610, 710) und zweite (212, 312, 412, 612, 712) Halbleiterschicht n-GaAs bzw. p-GaAs sind.

5. Vorrichtung nach Anspruch 1, ferner umfassend:
eine zweite Halbleiterschicht (212, 312, 412, 612, 712), die zwischen der ersten Halbleiterschicht (210, 310, 410, 610, 710) und der zweiten Elektrode (214, 314, 414, 614, 714) angeordnet ist, wobei die zweite Reflexionsschicht (208, 308, 408, 608, 708), die erste Halbleiterschicht (210, 310, 410, 610, 710) und die zweite Halbleiterschicht (212, 312, 412, 612, 712) eine n-p-n-Struktur bilden und wobei die Stromführungsregion durch Silicium(Si)-Diffusion und/oder Silicium(Si)-Implantation in der Kavität gebildet ist.

6. Vorrichtung nach Anspruch 5, wobei das erste Substrat (302) ein p-GaAs-Substrat ist, die erste Reflexionsschicht (304) eine p-DBR-Schicht ist, die zweite Reflexionsschicht (308) eine n-DBR-Schicht ist und die erste und zweite Halbleiterschicht (310, 312) p-GaAs bzw. n-GaAs sind.

7. Vorrichtung nach Anspruch 1, wobei das erste Substrat (202, 302, 402, 702) ein n-GaAs-Substrat ist, die erste Reflexionsschicht (204, 304, 404, 604, 704) eine n-DBR-Schicht ist, die zweite Reflexionsschicht (208, 308, 408, 608, 708) eine p-DBR-Schicht ist und die erste Halbleiterschicht (210, 310, 410, 610, 710) eine p-GaAs-Schicht ist.

8. Vorrichtung nach Anspruch 1, wobei das erste Substrat (202, 302, 402, 702) ein p-GaAs-Substrat ist, die erste Reflexionsschicht (204, 304, 404, 604, 704) eine p-DBR-Schicht ist, die zweite Reflexionsschicht (208, 308, 408, 608, 708) eine n-DBR-Schicht ist und die erste Halbleiterschicht (210, 310, 410, 610, 710) eine n-GaAs-Schicht ist.

9. Vorrichtung nach einem der vorhergehenden Ansprüche, wobei die aktive Region (206, 306, 406, 606, 706) aus mehreren Quantentöpfen gebildet ist.

10. Vorrichtung nach Anspruch 1, ferner umfassend eine zweite Halbleiterschicht (212, 312, 412, 612, 712) zwischen der ersten Halbleiterschicht (210, 310, 410, 610, 710) und der zweiten Elektrode (214, 314, 414, 614, 714).

11. Vorrichtung nach Anspruch 10, wobei die Stromführungsregion (220) in der Laserkavität liegt und so konfiguriert ist, dass Leitung durch die zweite Reflexionsschicht, die erste Halbleiterschicht (210, 310, 410, 610, 710) und die zweite Halbleiterschicht (212, 312, 412, 612, 712) erleichtert ist.

12. Vorrichtung nach Anspruch 11, wobei die Stromführungsregion (220) durch Zink(Zn)-Diffusion und/oder Zink(Zn)-Implantation gebildet ist.

13. Vorrichtung nach Anspruch 11, wobei die Stromführungsregion (220) durch Silicium(Si)-Diffusion und/oder Silicium(Si)-Implantation gebildet ist.

14. Vorrichtung nach Anspruch 10, wobei das erste Substrat (202, 302, 402, 702) und die erste Reflexionsschicht (204, 304, 404, 604, 704) die gleiche Dotierung aufweisen, wobei die zweite Reflexionsschicht (208, 308, 408, 608, 708) eine entgegengesetzte Dotierung aufweist und wobei die erste Halbleiterschicht (210, 310, 410, 610, 710) eine zur zweiten Halbleiterschicht (212, 312, 412, 612, 712) entgegengesetzte Dotierung aufweist.

15. Vorrichtung nach einem der Ansprüche 11 bis 14, ferner umfassend:
eine Tunnelübergangsschicht, die zwischen der aktiven Region und der zweiten Reflexionsschicht angeordnet ist.

16. Vorrichtung nach Anspruch 15, wobei das erste Substrat (202, 302, 402, 702) und die erste und zweite Reflexionsschicht (204, 208) die gleiche Dotierung aufweisen und wobei die erste und zweite Halbleiterschicht (210, 212) entgegengesetzte Dotierung aufweisen.

17. Vorrichtung nach Anspruch 16, wobei das erste Substrat (202, 302, 402, 702) ein n-GaAs-Substrat ist, die erste Reflexionsschicht (204, 304, 404, 604, 704) und die zweite Reflexionsschicht (208, 308, 408, 608, 708) n-DBR-Schichten sind und die erste und zweite Halbleiterschicht (210, 212) p-GaAs bzw. n-GaAs sind.

18. Vorrichtung nach einem der vorhergehenden Ansprüche, ferner umfassend:
einen Ausgangskoppler und
ein nichtlineares optisches Element, das zwischen der zweiten Elektrode und dem Ausgangskoppler angeordnet ist, wobei das nichtlineare optische Element und der Ausgangskoppler im Wesentlichen zu der Kavität ausgerichtet sind, die zwischen der Apertur und der Öffnung der zweiten Elektrode ausgebildet ist.

19. Vorrichtung nach Anspruch 18, wobei das nichtlineare optische Element ein SHG-Kristall zur Erzeugung einer zweiten Harmonischen ist.

20. Vorrichtung nach Anspruch 19, wobei das nichtlineare optische Element so konfiguriert ist, dass es eine Ausgangsfrequenz des oberflächenemittierenden Lasers verdoppelt.

21. Vorrichtung nach Anspruch 18, 19 oder 20, wobei das nichtlineare optische Element und der Ausgangskoppler außerhalb der zweiten Elektrodenschicht liegen und einen oberflächenemittierenden Laser mit externer vertikaler Kavität (VECSEL) bilden.

22. Vorrichtung nach Anspruch 18, 19, 20 oder 21, wobei der Ausgangskoppler ein Spiegel ist.

23. Vorrichtung nach einem der vorhergehenden Ansprüche, wobei die Stromsperrschicht auf der aktiven Region angeordnet ist.

24. Vorrichtung nach einem der vorhergehenden Ansprüche, wobei die Stromsperrschicht auf der zweiten Reflexionsschicht angeordnet ist.

## Revendications

1. Appareil à laser à émission de surface, comprenant :
un premier substrat (202, 302, 402, 702) qui est disposé entre une première couche d'électrode (201) et une première couche réfléchissante (204, 304, 404, 604, 704) ;
une deuxième couche d'électrode (214, 314, 414, 614, 714) qui comporte une ouverture ;
une région active (206, 306, 406, 606, 706) qui est disposée entre la première couche réfléchissante et une deuxième couche réfléchissante (208, 308, 408, 608, 708) ;
une couche de blocage de courant (207, 307, 407, 607, 707) qui est disposée entre la région active (206, 306, 406, 606, 706) et la deuxième couche d'électrode (214, 314, 414, 614, 714) afin de former un orifice (216, 316, 416, 616, 716) qui est alignée avec l'ouverture ; et
une première couche semi-conductrice (210, 310, 410, 610, 710) qui est disposée entre la deuxième couche d'électrode (214, 314, 414, 614, 714) et la deuxième couche réfléchissante (208, 308, 408, 608, 708),
**caractérisé par** une région de guidage de courant qui est une région dopée à conductivité supérieure qui s'étend à travers la première couche semi-conductrice (210, 310, 410, 610, 710), la région de guidage de courant étant une région dont la conductivité est supérieure à celle de la région qui entoure latéralement la région de guidage de courant.

2. Appareil selon la revendication 1, dans lequel la région de guidage de courant est dans une cavité et est configurée de manière à faciliter la conduction dans la cavité.

3. Appareil selon la revendication 1, comprenant en outre : une deuxième couche semi-conductrice (212, 312, 412, 612, 712) qui est disposée entre la première couche semi-conductrice (210, 310, 410, 610, 710) et la deuxième électrode (214, 314, 414, 614, 714), dans lequel la deuxième couche réfléchissante (208, 308, 408, 608, 708), la première couche semi-conductrice (210, 310, 410, 610, 710) et la deuxième couche semi-conductrice (212, 312, 412, 612, 712) forment une structure p-n-p, et dans lequel la région de guidage de courant est formée par au moins soit une diffusion de zinc (Zn), soit une implantation de zinc (Zn) dans la cavité.

4. Appareil selon la revendication 3, dans lequel le premier substrat (202, 302, 402, 702) est un substrat de n-GaAs, la première couche réfléchissante (204, 304, 404, 604, 704) est une couche de n-DBR, la deuxième couche réfléchissante (208, 308, 408, 608, 708) est une couche de p-DBR, et les première (210, 310, 410, 610, 710) et deuxième (212, 312, 412, 612, 712) couches semi-conductrices sont des couches de n-GaAs et p-GaAs, respectivement.

5. Appareil selon la revendication 1, comprenant en outre une deuxième couche semi-conductrice (212, 312, 412, 612, 712) qui est disposée entre la première couche semi-conductrice (210, 310, 410, 610, 710) et la deuxième électrode (214, 314, 414, 614, 714), dans lequel la deuxième couche réfléchissante (208, 308, 408, 608, 708), la première couche semi-conductrice (210, 310, 410, 610, 710) et la deuxième couche semi-conductrice (212, 312, 412, 612, 712) forment une structure n-p-n, et dans lequel la région de guidage de courant est constituée par au moins soit une diffusion de silicium (Si), soit une implantation de silicium (Si) dans la cavité.

6. Appareil selon la revendication 5, dans lequel le premier substrat (302) est un substrat de p-GaAs, la première couche réfléchissante (304) est une couche de p-DBR, la deuxième couche réfléchissante (308) est une couche de n-DBR, et les première et deuxième couches semi-conductrices (310, 312) sont des couches de p-GaAs et n-GaAs, respectivement.

7. Appareil selon la revendication 1, dans lequel le premier substrat (202, 302, 402, 702) est un substrat de n-GaAs, la première couche réfléchissante (204, 304, 404, 604, 704) est une couche de n-DBR, la deuxième couche réfléchissante (208, 308, 408, 608, 708) est une couche de p-DBR, et la première couche semi-conductrice (210, 310, 410, 610, 710) est une couche de p-GaAs.

8. Appareil selon la revendication 1, dans lequel le premier substrat (202, 302, 402, 702) est un substrat de p-GaAs, la première couche réfléchissante (204, 304, 404, 604, 704) est une couche de p-DBR, la deuxième couche réfléchissante (208, 308, 408, 608, 708) est une couche de n-DBR, et la première couche semi-conductrice (210, 310, 410, 610, 710) est une couche de n-GaAs.

9. Appareil selon l'une quelconque des revendications précédentes, dans lequel la région active (206, 306, 406, 606, 706) est constituée de multiples puits quantiques.

10. Appareil selon la revendication 1, comprenant en outre une deuxième couche semi-conductrice (212, 312, 412, 612, 712) qui est disposée entre la première couche semi-conductrice (210, 310, 410, 610, 710) et la deuxième électrode (214, 314, 414, 614, 714).

11. Appareil selon la revendication 10, dans lequel la région de guidage de courant (220) se trouve dans la cavité du laser et est configurée de manière à faciliter la conduction à travers la deuxième couche réfléchissante, la première couche semi-conductrice (210, 310, 410, 610, 710) et la deuxième couche semi-conductrice (212, 312, 412, 612, 712).

12. Appareil selon la revendication 11, dans lequel la région de guidage de courant (220) est constituée par au moins soit une diffusion de zinc (Zn), soit une implantation de zinc (Zn).

13. Appareil selon la revendication 11, dans lequel la région de guidage de courant (220) est constituée par au moins soit une diffusion de silicium (Si), soit une implantation de zinc (Si).

14. Appareil selon la revendication 10, dans lequel le premier substrat (202, 302, 402, 702) et la première couche réfléchissante (204, 304, 404, 604, 704) présentent un dopage identique, dans lequel la deuxième couche réfléchissante (208, 308, 408, 608, 708) présente un dopage opposé, et dans lequel la première couche semi-conductrice (210, 310, 410, 610, 710) présente un dopage opposé à celui de la deuxième couche semi-conductrice (212, 312, 412, 612, 712).

15. Appareil selon l'une quelconque des revendications 11 à 14, comprenant en outre :
une couche de jonction de tunnel qui est disposée entre la région active et la deuxième couche réfléchissante.

16. Appareil selon la revendication 15, dans lequel le premier substrat (202, 302, 402, 702) et les première et deuxième couches réfléchissantes (204, 208) présentent un dopage identique, et dans lequel les première et deuxième couches semi-conductrices (210, 212) présentent un dopage opposé.

17. Appareil selon la revendication 16, dans lequel le premier substrat (202, 302, 402, 702) est un substrat de n-GaAs, la première couche réfléchissante (204, 304, 404, 604, 704) et la deuxième couche réfléchissante (208, 308, 408, 608, 708) sont des couches de n-DBR, et les première et deuxième couches semi-conductrices (210, 212) sont des couches de p-GaAs et n-GaAs, respectivement.

18. Appareil selon l'une quelconque des revendications précédentes comprenant en outre :
un coupleur de sortie ; et
un élément optique non linéaire qui est disposé entre la deuxième électrode et le coupleur de sortie, dans lequel l'élément optique non linéaire et le coupleur de sortie sont essentiellement alignés avec la cavité qui est formée entre l'orifice et l'ouverture de la deuxième électrode.

19. Appareil selon la revendication 18, dans lequel l'élément optique non linéaire est un cristal de génération de deuxième harmonique (SHG).

20. Appareil selon la revendication 19, dans lequel l'élément optique non linéaire est configuré pour doubler une fréquence de sortie du laser à émission de surface.

21. Appareil selon la revendication 18, 19 ou 20, dans lequel l'élément optique non linéaire et le coupleur de sortie sont externes à la deuxième couche d'électrode et forment un laser à émission de surface à cavité externe verticale (VECSEL).

22. Appareil selon la revendication 18, 19, 20 ou 21, dans lequel le coupleur de sortie est un miroir.

23. Appareil selon l'une quelconque des revendications précédentes, dans lequel la couche de blocage de courant est disposée sur la région active.

24. Appareil selon l'une quelconque des revendications précédentes, dans lequel la couche de blocage de courant est disposée sur la deuxième couche réfléchissante.
